Europäisches Patentamt

European Patent Office

Office européen des brevets

(19)

(11) **EP 0 571 209 B1**

(12) **EUROPEAN PATENT SPECIFICATION**

(45) Date of publication and mention
of the grant of the patent:
**11.11.1998 Bulletin 1998/46**

(51) Int Cl.⁶: **G11C 11/407**, G11C 7/00

(21) Application number: **93303922.4**

(22) Date of filing: **20.05.1993**

(54) **Bit-line sensing in semiconductor memory devices**

Bitleitungsabtastung in Halbleiterspeicheranordnungen

Détection des lignes de bits dans dispositifs de mémoire à semi-conducteur

(84) Designated Contracting States:
**DE FR GB IT**

(30) Priority: **20.05.1992 KR 847392**

(43) Date of publication of application:
**24.11.1993 Bulletin 1993/47**

(73) Proprietor: **SAMSUNG ELECTRONICS CO., LTD.**
**Suwon-city, Kyungki-do 441-373 (KR)**

(72) Inventor: **Kim, Myung-Ho**
**Kwonsun-gun, Suwon-city, Kyungki-do (KR)**

(74) Representative: **Stanley, David William et al**
**DIBB LUPTON**
**BROOMHEAD**
**117 The Headrow, Leeds LS1 5JX (GB)**

(56) References cited:
**EP-A- 0 165 612**          **EP-A- 0 249 413**

Remarks:
The file contains technical information submitted
after the application was filed and not included in this
specification

## Description

The present invention relates to semiconductor memory devices, and particularly to circuits for sensing voltage level on a bit line in a semiconductor memory device.

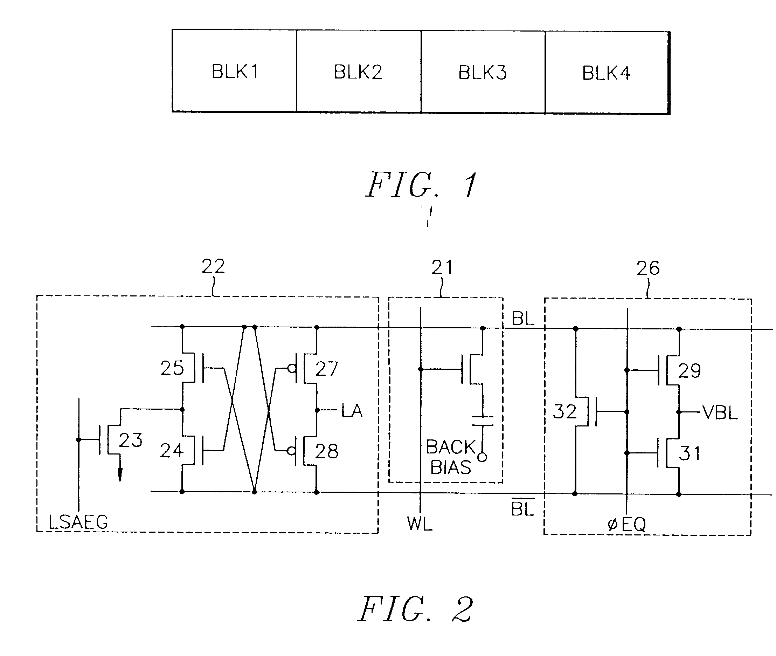

The state of the art in semiconductor memory device design has been reviewed in terms of essential design parameters, such as bit-line sensing noise which might be reduced by dividing a memory cell array into several blocks, for example four memory cell array blocks BLK1, BLK2, BLK3 and BLK4 as shown in Figure 1 of the accompanying diagrammatic drawings, or by decreasing the mutual capacitance between one bit line and an adjacent line. The sensing operations of bit lines in dynamic random access memory (DRAM) is made to all selected bit lines, to wherever those selected bit lines belong, at the same time, while in other devices such as field memory (or frame memory) or DRAM-equipped application specific integrated circuit (ASIC), the sensing operation can be provided to each one of a plurality of memory cell array blocks at different times due to there being sufficient row access time, and so disperse noise and peak current.

In Figure 2 of the accompanying diagrammatic drawings, as a well known column circuitry of DRAM, a sense amplifier 22 consisting of n-type MOS transistors 23, 24 and 25 and p-type MOS transistors 27 and 28 amplifies and develops the voltage difference between bit lines BL and $\overline{BL}$ after a word line WL is activated to select a memory cell 21, being controlled by sensing signals LA and LSAEG. An equalizing circuit 26 consisting of n-type MOS transistors 29, 31 and 32 pre-charges and equalizes both bit lines with equalizing voltage VBL before and after a read or write operation of the DRAM, being controlled by equalizing signal $\phi$EQ.

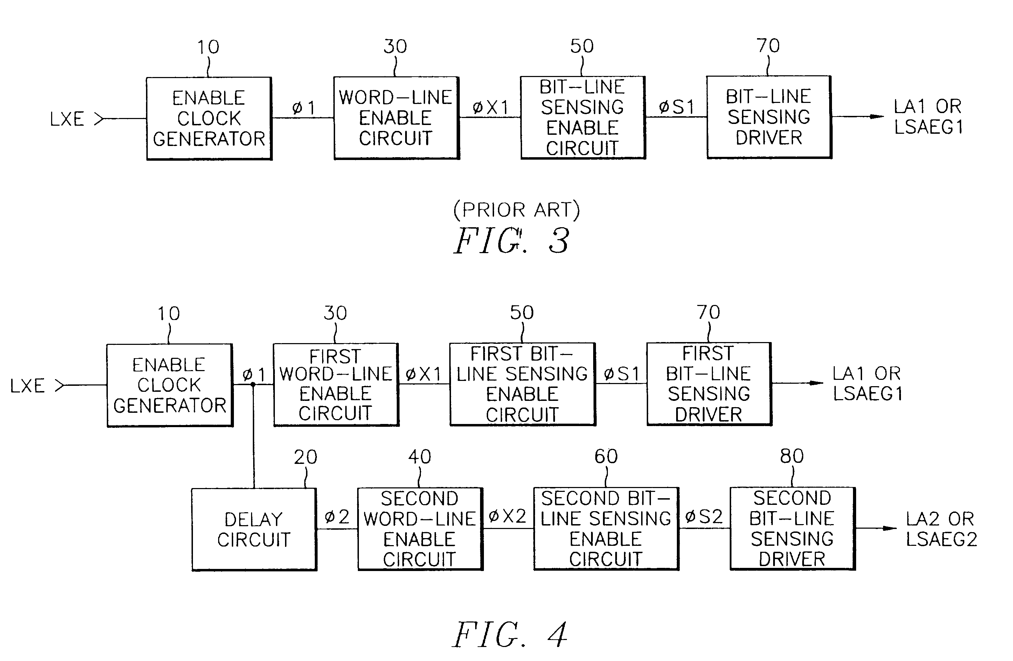

Figure 3 of the accompanying diagrammatic drawings shows a conventional bit-line sensing control circuit consisting of an enable clock generator 10, a word-line enable circuit 30, a bit-line sensing enable circuit 50 and a bit-line sensing driver 70. The enable clock generator 10 receives an address informing signal LXE which is obtained when an external address becomes valid by transition of a row address strobe signal ($\overline{RAS}$) at the logic state "low", and generates an initial activating clock $\phi$1. From the initial activating clock $\phi$1, a word-line enable circuit 30 generates word-line enable signal $\phi$X1. Then the bit-line sensing enable circuit 50 generates a bit-line sensing enable signal $\phi$S1 from the word-line enable signal $\phi$X1, and as a result p- or n-type sensing signal LA1 or LSAEG1 is generated from the bit-line sensing driver 70 which receives the bit-line sensing enable signal $\phi$S1, the sensing signals being applied to the sense amplifier 22 of Figure 2. The number of sense amplifiers like the sense amplifier 22 corresponds to the number of columns in the memory cell array blocks BLK1, BLK2, BLK3 and BLK4.

Since, however, one of the sense amplifiers embedded in each one of the memory cell array blocks is put into a simultaneous sensing operation together with other sense amplifiers belonging to other memory cell array blocks, selected pairs of bit lines are simultaneously developed, the bit line BL going to "high" or "low" level and the bit line $\overline{BL}$ to "low" or "high" level. It is, also, well known that a noise such as a spike current may be generated during the bit-line sensing operation because of a large bit-line voltage swing between power supply voltage and ground voltage. Therefore, in the conventional scheme in which all bit lines selected in each of the memory cell array blocks are put into the sensing operation at the same time, the sensing noises due to the spike currents accumulate simultaneously, and this can result in malfunction of the memory operation.

To solve the above problem EP-A-0 165 612 proposes a semiconductor memory circuit which can operate with reduced value of peak currents. The memory circuit includes two or more memory cell array blocks each having a plurality of memory cells and a peripheral circuit for achieving selective access operation is provided for each block. At least a timing signal and its delayed timing signals are generated in response to a control signal. Both of the timing signal and the delayed timing signal are used to enable the peripheral circuits of different blocks at different timing (see preamble of claim 1).

Preferred embodiments of the present invention aim to provide a bit-line sensing control circuit which can reduce the sensing noises due to spike currents during bit-line sensing operation in a semiconductor memory device.

It is another aim to provide a bit-line sensing control circuit which can reduce the sensing noises due to spike currents during bit-line sensing operation in a semiconductor memory device having a plurality of bit-line pairs belonging to a plurality of memory cell array blocks therein.

The invention is set forth in claim 1.

Preferably, said first initial activating clock is generated according to an address informing signal.

Preferably, said first means comprises means for sequentially generating a first word-line enable signal, a first bit-line sensing enable signal and a first bit-line sensing signal.

Preferably, said second means comprises means for sequentially generating a second word-line enable signal, a second bit-line sensing enable signal and a second bit-line sensing signal.

A bit-line sensing control circuit as above may further comprise a first equalizing signal generator for generating a first equalizing signal applied to said first block before or after a bit line sensing operation, and a second equalizing signal generator for generating a second equalizing signal applied to said second block before or after a bit line sensing operation.

For a better understanding of the invention, and to show how the same may be carried into effect, reference will now be made, by way of example, to Figures 1 to 3 as mentioned above and with reference to Figures 4 to 7 of the accompanying diagrammatic drawings, in which:

Figure 4 is a functional block diagram illustrating one example of a conventional bit-line sensing control circuit;

Figure 5A is a circuit diagram of a first or second word-line enable circuit of Figure 4;

Figure 5B is a circuit diagram of a first or second bit-line sensing enable circuit of Figure 4;

Figure 5C is a circuit diagram of a first or second bit-line sensing driver of Figure 4;

Figure 5D is a circuit diagram of a delay circuit of Figure 4;

Figure 6A shows a circuit which generates a first equalizing signal;

Figure 6B shows a circuit which generates a second equalizing signal; and

Figure 7 is a timing diagram illustrating a bit-line sensing operation.

In the figures, like reference numerals denote like or corresponding parts.

Referring to Figure 4, the bit-line sensing control circuit has an enable clock generator 10 generating a first initial activating clock $\phi1$ from an address informing clock LXE, a delay circuit 20 generating a second initial activating clock $\phi2$ delayed from the first initial activating clock $\phi1$, a first word-line enable circuit 30 generating a first word-line enable signal $\phi X1$ from the first initial activating clock $\phi1$, a second word-line enable circuit 40 generating a second word-line enable signal $\phi X2$ from the second initial activating clock $\phi2$, a first bit-line sensing enable circuit 50 generating a first bit-line sensing enable signal $\phi S1$ from the first word-line enable signal $\phi X1$, a second bit-line sensing enable circuit 60 generating a second bit-line sensing enable signal $\phi S2$ from the second word-line enable signal $\phi X2$, a first bit-line sensing driver 70 as a result generating a first p-type or n-type sensing signal LA1 or LSAEG1 from the first bit-line sensing enable signal $\phi S1$, and a second bit-line sensing driver 80 as a result generating a second p-type or n-type sensing signal LA2 or LSAEG2. Those sensing signals LA1, LSAEG1, or LA2 and LSAEG2 are applied to a sense amplifier like that of Figure 2.

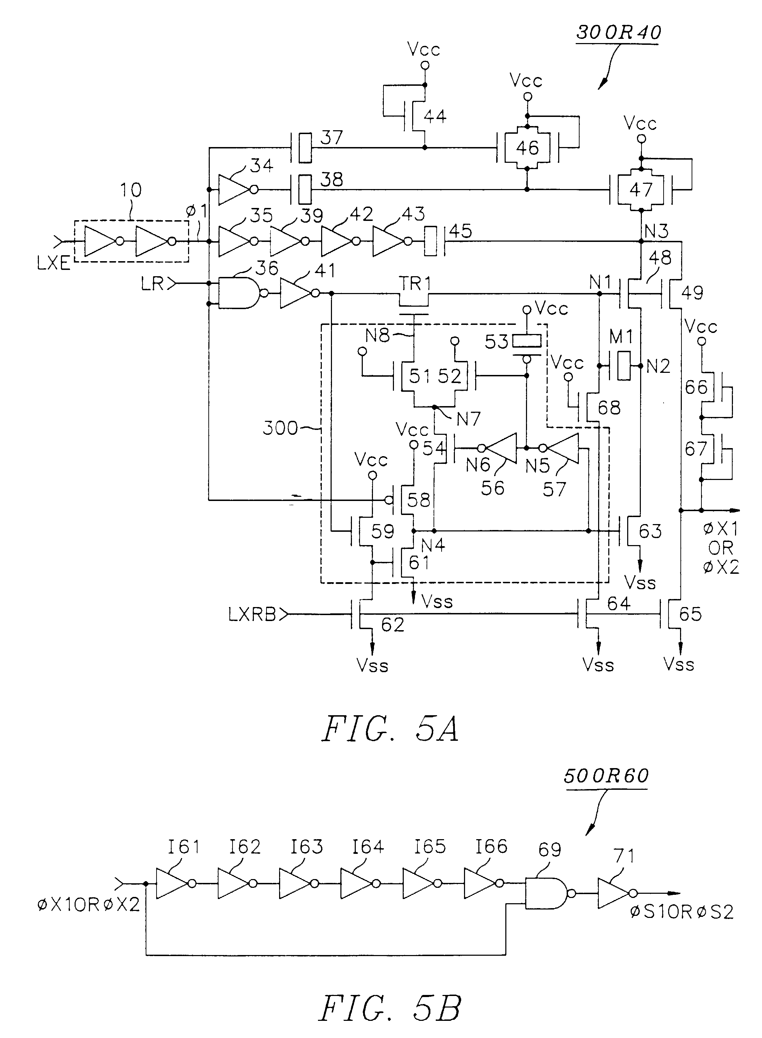

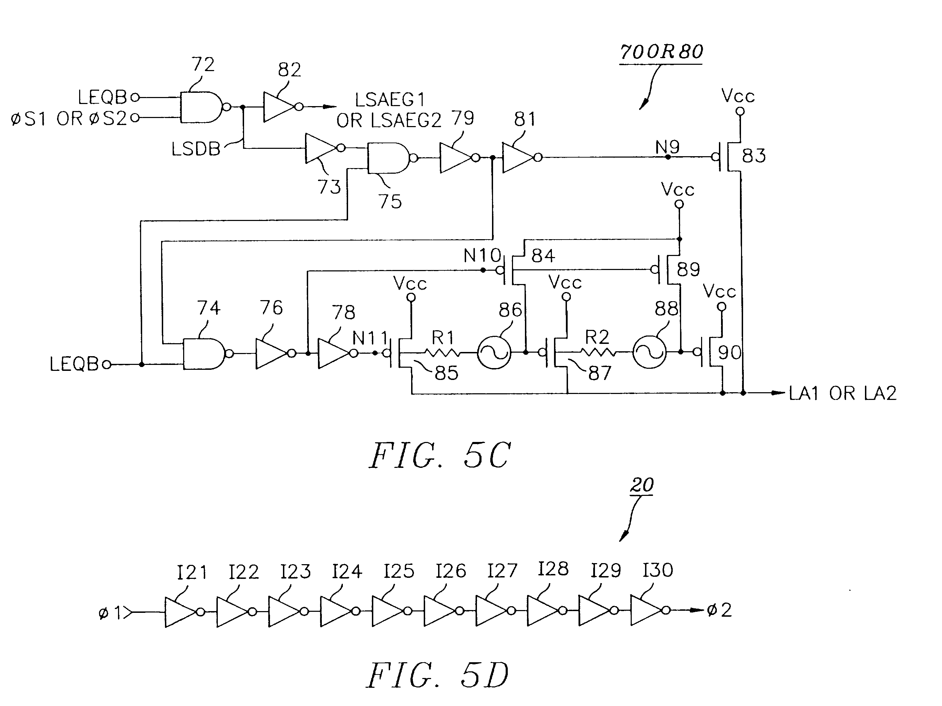

Note that detail circuit features of the enable clock generator 10, the first word-line enable circuit 30, the first bit-line sensing enable circuit 50 and the first bit-line sensing driver 70 may be the same as those employed in the conventional circuit as shown in Figure 3, and also the second circuits 40, 60 and 80 may have the same circuit architectures as those of their corresponding first circuits 30, 50 and 70, as shown in Figure 5A, Figure 5B and Figure 5C, respectively. The delay circuit 20, as shown in Figure 5D, can be formed of a serial chain consisting of a plurality of inverters as an example, ten inverters I21 to I30. The delay time of the second initial activating clock $\phi2$ from the first initial activating clock $\phi1$ is determined by the number of inverters in the delay circuit 20. In the description of the present embodiment hereinafter, generating mechanisms of the first sensing signal LA1 (or LSAEG1), and the second sensing signals LA2 (or LSAEG2) are identically the same as each other, except for the difference of time delay between them by the delay circuit 20.

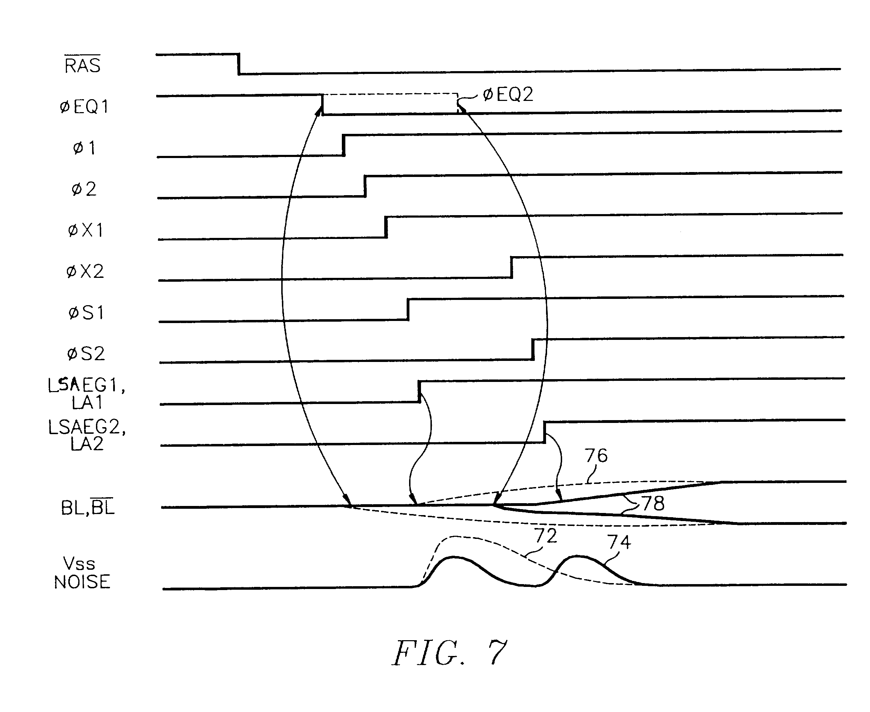

Referring to Figure 7, when a row address strobe signal $\overline{RAS}$ is in its precharge cycle as a "high" level, both a $\overline{RAS}$ master clock LR, which has a complementary logic level with that of the signal $\overline{RAS}$ and applied to the first word-line enable circuit 30 (the numeral 40 represents the case of the second word-line enable circuit for generating the second word-line enable signal $\phi X2$) of Figure 5A, and the address informing clock LXE are at "low" level, and a $\overline{RAS}$ slave clock LXRB which has an identical logic level with that of the signal $\overline{RAS}$ and is generated in accordance with the $\overline{RAS}$ master clock LR is at "high" level. Then in Figure 5A, voltage levels at a first node N1, a second node N2 and a fifth node N5 become "low" level, and voltage levels at a third node N3, a fourth node N4. a sixth node N6, a seventh node N7 and an eighth node N8 all become "high" level, resulting in that voltage level of the first word-line enable signal $\phi X1$ (or second word-line enable clock $\phi X2$) still remains "low".

When the row address strobe signal $\overline{RAS}$ is in its active cycle at "low" level, the $\overline{RAS}$ master clock LR, the address informing signal LXE and $\overline{RAS}$ the master clock LXRB have voltage levels such as "high", "high" and "low". Then in Figure 5A, voltage levels at the first node N1, the second node N2, the third node N3, the fifth node N5, the seventh node N7 and the eighth node N8 become "high", and those at the fourth node N4 and sixth node N6 become "high", resulting in the voltage level of the first word-line enable signal $\phi X1$ (or second word-line enable signal $\phi X2$), as shown in Figure 7, becoming "high", practically at the voltage level of Vcc+(1/2)Vcc. The circuit component 300 encircled by a broken line in Figure 5A is a boost circuit which can increase a voltage level of the first word-line enable signal $\phi X1$ (or the second word-line enable signal $\phi X2$) to the voltage level of Vcc+(1/2)Vcc, by means of a pumping operation of a capacitor C1 in which its one electrode receives a pumping signal through a transistor TR1 from an output of a NAND gate 36 which is controlled by the address informing signal LXE and the $\overline{RAS}$ master clock LR.

The first word-line enable signal $\phi X1$ (or second word-line enable signal $\phi X2$) is applied to the bit-line sensing enable circuit 50 (the numeral 40 represents the case of the second bit-line sensing enable circuit for generating the second bit-line sensing enable signal φS2) of Figure 5B. A NAND gate 69, in Figure 5B, receiving one input signal passed through serially connected inverters I61, I62, I63, I64, I65 and I66 from the first word-line enable signal φX1 (or the second word-line enable signal φX2) and the other input signal as the first word-line enable signal φX1 (or the second word-line enable signal φX2), determines an activating time and a pulse width of the first bit-line sensing enable signal φS1 (or the second bit-line sensing enable signal φS2), in order to make the sense amplifier coupled to a selected pair of bit lines selected be activated after the selected bit-line pair has been developed by charge sharing between the selected memory cell and the bit line.

Referring to Figure 5C showing the first bit-line sensing driver 70 (the numeral 80 represents the case of the second bit-line sensing driver for generating the second sensing signals LA2 and LSAEG2), the first n-type sensing signal LSAEG1 (or the second n-type sensing signal LSAEG2) is generated through a NAND gate 72 and an inverter 82, the NAND gate receiving the first bit-line sensing enable signal φS1 (or the second bit-line sensing enable signal φS2) and being controlled by a block selecting signal LEQB. The first n-type sensing signal LSAEG (or the second n-type sensing signal LSAEG2) is generated as shown in Figure 7 and then turns on the n-type sense amplifier as shown in Figure 2. According to the present invention the first n-type sensing signal LSAEG1 is applied to n-type sense amplifiers selected in the first and third memory cell array blocks BLK1 and BLK3 of Figure 1, the second n-type sensing signal LSAEG2 is applied to n-type sense amplifiers selected in the second and fourth memory cell array blocks BLK2 and BLK4 after elapsing time established by the delay circuit 20, and vice versa.

On the other hand, in addition to that, an output signal LSDB of the NAND gate 72, at "low" level, is applied to a gate of a pull-up transistor 83 through an inverter 73, a NAND gate 75, and an inverter 79 and 81, to provide the first p-type sensing signal LA1 (or the second p-type sensing signal LA2 after elapsing time established by the delay circuit 20) for starting at a "high" level. An output of the inverter 79 is applied to a NAND gate 74 controlled by the block selecting signal LEQB and thereby the first p-type sensing signal LA1 (or the second p-type sensing signal LA2), being preliminary on its way to the "high" level, is further activated to full "high" level by means of the additional pull-up operation of transistors 85, 87 and 90. Such generating sequence for the p-type sensing signals LA1 or LA2 is for the purpose of allowing the activation timing of p-type sense amplifier as main bit-line sensing and amplifying means to correspond with the charge sharing timing between the bit line and the memory cell.

The delay interval between the first sensing signals LA1, LSAEG1 and the second sensing signals LA2, LSAEG2 is about 20ns, which is a suitable time for the noises due to spike currents during sensing operation by the first sensing signal LA1 and LSAEG1 to have disappeared. The same relation applies between the first and second n-type sensing signals LSAEG1 and LSAEG2, assuming that the first p-type sensing signal LA1 is applied to p-type sense amplifiers selected in the first and third memory cell array blocks BLK1 and BLK3 of Figure 1, the second p-type sensing signal LA2 is applied to p-type sense amplifiers selected in the second and fourth memory cell array blocks BLK2 and BLK4 after elapsing the time established by the delay circuit 20, and vice versa.

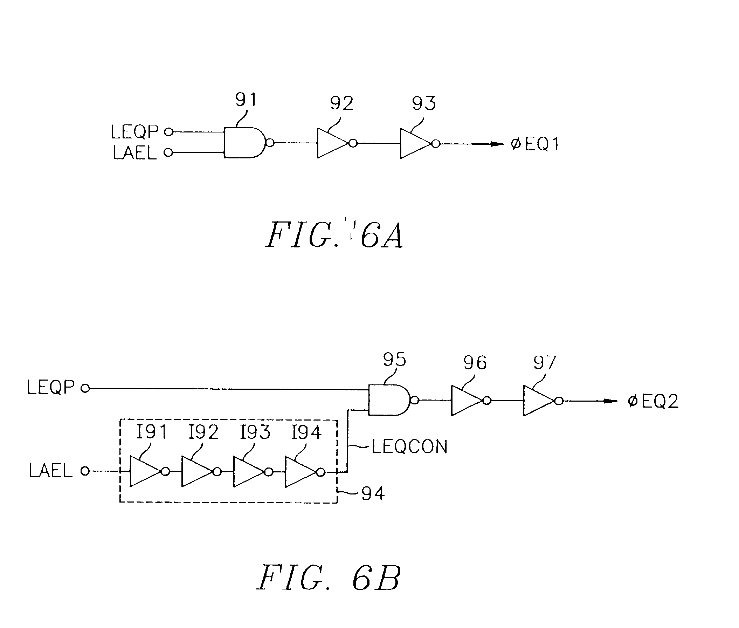

Referring to Figures 6A and 6B, in order to allow an equalizing operation of bit lines to coincide with the bit line sensing operation according to the illustrated embodiment of this invention, before or after completing the bit line sensing operation, the embodiment provides two equalizing signal generators. A first equalizing signal generator as shown in Figure 6A is formed of a NAND gate 91 receiving a bit-line precharge control signal LEQP and an equalizing timing control signal LAEL, and inverters 92 and 93 serially connected from the NAND gate 91, and generates a first equalizing signal φEQ1. A second equalizing signal generator as shown in Figure 6B is formed of a chain of inverters I91, I92, I93 and I94, a NAND gate 95 receiving the equalizing timing control signal LAEL through the inverter chain and the bit-line precharge control signal LEQP, and inverters 96 and 97 serially connected from the NAND gate 95, and generates a second equalizing signal φEQ2. The first equalizing signal φEQ1 is applied to an equalizing circuit in the first and third memory cell array blocks BLK1 and BLK3 before or after the bit line sensing operation of the blocks BLK1 and BLK3 by the first sensing signals LA1 and LSAEG1, while the second equalizing signal φEQ2 is applied to an equalizing circuit in the second and fourth memory cell array blocks BLK2 and BLK4 before or after the bit line sensing operation of the blocks BLK1 and BLK3 by the second sensing signals LA2 and LSAEG2, as shown in Figure 7.

As described above, according to the embodiment of this invention, since the timings of sensing and equalizing with bit lines selected in groups of alternate memory cell array blocks are separated from each other, noise crowding during the bit line sensing operation may be largely eliminated. Also, the semiconductor memory device with multi-bit-line sensing performance may be free from sensing noises due to spike currents when the voltage level of a bit line is going up to the power supply level or down to the ground voltage level during the sensing operation.

The term "ground potential" (or like terms such as "ground voltage" or "earth" potential or voltage) is used conveniently in this specification to denote a reference potential. As will be understood by those skilled in the art, although such reference potential may typically be zero potential, it is not essential that it is so, and may be a reference potential other than zero.

## Claims

1. A bit-line sensing control circuit for a semiconductor memory device having a plurality of memory cell array blocks (BLK1-4), the circuit comprising:

   first means (30, 50, 70) for activating a word line and a bit line which belong to a first block of said plurality of memory cell array blocks (BLK1-4), in response to a first initial activating clock ($\phi$1);

   a delay circuit (20) for generating a second initial activating clock ($\phi$2) from said first initial activating clock ($\phi$1); and

   second means (40, 60, 80) for activating a word line and a bit line which belong to a second block of said plurality of memory cell array blocks (BLK1-4), in response to said second initial activating clock ($\phi$2);

   **characterized in that:**

   the first and second means (30, 50, 70 : 40, 60, 80) are arranged to activate respective first and second groups of alternate memory cell array blocks (BLK1, BLK3; BLK2, BLK4) in a row of memory cell array blocks, wherein each group comprises more than one memory cell array block.

2. A bit-line sensing control circuit according to claim 1, wherein said first initial activating clock ($\phi$1) is generated according to an address informing signal (LXE).

3. A bit-line sensing control circuit according to claim 1 or 2, wherein said first means (30, 50, 70) comprises means for sequentially generating a first word-line enable signal ($\phi$X1), a first bit-line sensing enable signal ($\phi$S1) and a first bit-line sensing signal (LA1 or LSAEG1).

4. A bit-line sensing control circuit according to claim 1, 2 or 3, wherein said second means (40, 60, 80) comprises means for sequentially generating a second word-line enable signal ($\phi$X2), a second bit-line sensing enable signal ($\phi$S2) and a second bit-line sensing signal (LA2 or LSAEG2).

5. A bit-line sensing control circuit according to claim 1, 2, 3 or 4, further comprising a first equalizing signal generator (91, 92, 93) for generating a first

equalizing signal ($\phi$EQ1) applied to said first group of blocks before or after a bit line sensing operation, and a second equalizing signal generator (94-97) for generating a second equalizing signal ($\phi$EQ2) applied to said second group of blocks before or after a bit line sensing operation.

## Patentansprüche

1. Bitleitungs-Abtaststeuerschaltung für ein Halbleiterspeicherbauelement mit einer Vielzahl von Speicherzellenanordnungsblöcken (BLK1-4), wobei die Schaltung enthält:

   erste Mittel (30, 50, 70) zum Aktivieren einer Wortleitung und einer Bitleitung, welche zu einem ersten Block der Vielzahl von Speicherzellenanordnungsblöcken (BLK1-4) gehören, in Reaktion auf einen ersten Anfangsaktivierungstakt ($\phi$1);
   eine Verzögerungsschaltung (20) zum Erzeugen eines zweiten Anfangsaktivierungstaktes ($\phi$2) aus dem ersten Anfangsaktivierungstaktes ($\phi$1); und
   zweite Mittel (40, 60, 80) zum Aktivieren einer Wortleitung und einer Bitleitung, welche zu einem zweiten Block der Vielzahl von Speicherzellenanordnungsblöcken (BLK1-4) gehören, in Reaktion auf den zweiten Anfangsaktivierungstakt ($\phi$2);

   dadurch gekennzeichnet, daß

   die ersten und zweiten Mittel (30, 50, 70; 40, 60, 80) angeordnet sind, um entsprechende erste und zweite Gruppen von alternativen Speicherzellenanordnungsblöcken (BLK1, BLK3; BLK2, BLK4) in einer Reihe von Speicherzellenanordnungsblöcken zu aktivieren, wobei jede Gruppe mehr als einen Speicherzellenanordnungsblock aufweist.

2. Bitleitungs-Abtaststeuerschaltung nach Anspruch 1, wobei der erste Anfangsaktivierungstakt ($\phi$1) gemäß einem Adreßinformationssignal (LXE) erzeugt wird.

3. Bitleitungs-Abtaststeuerschaltung nach den Ansprüchen 1 oder 2, wobei die ersten Mittel ( 30, 50, 70) Mittel zum sequenziellen Erzeugen eines ersten Wortleitungs-Freigabesignals ($\phi$X1), eines ersten Bitleitungs-Abtastfreigabesignals ($\phi$S1) und eines ersten Bitleitungs-Abtastsignals (LA1 oder LSAEG1) aufweisen.

**4.** Bitleitungs-Abtaststeuerschaltung nach den Ansprüchen 1, 2 oder 3,
wobei die zweiten Mittel (40, 60, 80) Mittel zum sequentiellen Erzeugen eines zweiten Wortleitungs-Freigabesignals ($\phi$X2), eines zweiten Bitleitungs-Abtastfreigabesignals ($\phi$S2) und eines zweiten Bitleitungs-Abtastsignals (LA2 oder LSAEG2) aufweisen.

**5.** Bitleitungs-Abtaststeuerschaltung nach den Ansprüchen 1, 2, 3 oder 4,
weiterhin enthaltend einen ersten Equalizersignalerzeuger (91, 92, 93) zum Erzeugen eines ersten Equalizersignals ($\phi$EQ1), welches der ersten Gruppe von Blöcken vor oder nach einer Bitleitung-Abtastoperation zugeführt wird, und eines zweiten Equalizersignalgenerator (94-97) zum Erzeugen eines zweiten Equalizersignals ($\phi$EQ2), welches der zweiten Gruppe von Blöcken vor oder nach einer Begleitungs-Abtastoperation zugeführt wird.

## Revendications

**1.** Circuit de commande de lecture de ligne de bit pour un composant mémoire à semi-conducteur comportant une pluralité de blocs matriciels (BLK1 à 4) de cellules de mémoire, le circuit comprenant :

un premier moyen (30, 50, 70) destiné à activer une ligne de mots et une ligne de bit qui appartiennent à un premier bloc de ladite pluralité de blocs matriciels (BLK1 à 4) de cellules de mémoire, en réponse à un premier signal d'horloge ($\phi$1) d'activation initiale ;
un circuit (20) à retard destiné à produire un second signal d'horloge ($\phi$2) d'activation initiale à partir dudit premier signal d'horloge ($\phi$1) d'activation initiale ; et
un second moyen (40, 60, 80) destiné à activer une ligne de mots et une ligne de bit qui appartiennent à un second bloc de ladite pluralité de blocs matriciels (BLK1 à 4) de cellules de mémoire, en réponse audit second signal d'horloge ($\phi$2) d'activation initiale ;

caractérisé en ce que :

les premier et second moyens (30, 50, 70 ; 40, 60, 80) sont agencés pour activer des premier et second groupes respectifs de blocs matriciels (BLK1, BLK3 ; BLK2, BLK4) de cellules de mémoire qui se trouvent dans une rangée de blocs matriciels de cellules de mémoire, dans lequel chaque groupe comprend plus d'un bloc matriciel de cellules de mémoire.

**2.** Circuit de commande de lecture de ligne de bit selon la revendication 1, dans lequel ledit premier signal d'horloge ($\phi$1) d'activation initiale est produit selon un signal (LXE) d'information d'adresse.

**3.** Circuit de commande de lecture de ligne de bit selon la revendication 1 ou 2, dans lequel ledit premier moyen (30, 50, 70) comprend un moyen destiné à produire séquentiellement un premier signal ($\phi$X1) de validation de ligne de mots, un premier signal ($\phi$S1) de validation de lecture de ligne de bit et un premier signal (LA1, ou LSAEG1) de lecture de ligne de bit.

**4.** Circuit de commande de lecture de ligne de bit selon la revendication 1, 2 ou 3, dans lequel ledit second moyen (40, 60, 80) comprend un moyen destiné à produire séquentiellement un second signal ($\phi$X2) de validation de ligne de mots, un second signal ($\phi$S2) de validation de lecture de ligne de bit et un second signal (LA2, ou LSAEG2) de lecture de ligne de bit.

**5.** Circuit de commande de lecture de ligne de bit selon la revendication 1, 2, 3 ou 4, comprenant en outre un premier générateur (91, 92, 93) de signal d'égalisation destiné à produire un premier signal ($\phi$EQ1) d'égalisation appliqué audit premier groupe de blocs avant, ou après, une opération de lecture de ligne de bit, et un second générateur (94-97) de signal d'égalisation destiné à produire un second signal ($\phi$EQ2) d'égalisation appliqué audit second groupe de blocs avant, ou après, une opération de lecture de ligne de bits.

EP 0 571 209 B1

| BLK1 | BLK2 | BLK3 | BLK4 |
|------|------|------|------|

*FIG. 1*

*FIG. 2*

| 10 | | 30 | | 50 | | 70 | |
|---|---|---|---|---|---|---|---|
| LXE ⟩ | ENABLE CLOCK GENERATOR | ∅1 | WORD−LINE ENABLE CIRCUIT | ∅X1 | BIT−LINE SENSING ENABLE CIRCUIT | ∅S1 | BIT−LINE SENSING DRIVER | → LA1 OR LSAEG1 |

(PRIOR ART)

*FIG. 3*

| 10 | | 30 | | 50 | | 70 | |
|---|---|---|---|---|---|---|---|
| LXE ⟩ | ENABLE CLOCK GENERATOR | ∅1 | FIRST WORD−LINE ENABLE CIRCUIT | ∅X1 | FIRST BIT−LINE SENSING ENABLE CIRCUIT | ∅S1 | FIRST BIT−LINE SENSING DRIVER | → LA1 OR LSAEG1 |

| 20 | | 40 | | 60 | | 80 | |
|---|---|---|---|---|---|---|---|
| DELAY CIRCUIT | ∅2 | SECOND WORD−LINE ENABLE CIRCUIT | ∅X2 | SECOND BIT−LINE SENSING ENABLE CIRCUIT | ∅S2 | SECOND BIT−LINE SENSING DRIVER | → LA2 OR LSAEG2 |

*FIG. 4*

FIG. 5A

FIG. 5B

FIG. 5C

FIG. 5D

FIG. 6A

FIG. 6B

*FIG. 7*

EP 0 571 209 B1